# EUROPEAN PATENT SPECIFICATION

(11) **EP 2 663 604 B1**
(45) Date of publication and mention of the grant of the patent: **01.07.2020**
(21) Application number: 12734493.5
(22) Date of filing: 10.01.2012
(51) Int. Cl.: C09K 3/14, H01L 21/321

(54) **METAL-PASSIVATING CMP COMPOSITIONS AND METHODS**
METALLPASSIVIERENDE CMP-ZUSAMMENSETZUNGEN UND VERFAHREN DAMIT
COMPOSITIONS ET PROCÉDÉS DE POLISSAGE CHIMICO-MÉCANIQUE (CMP) DE PASSIVATION DE MÉTAL

(30) Priority: 11.01.2011 US 201113004113
(43) Date of publication of application: 20.11.2013
(73) Proprietor: Cabot Microelectronics Corporation, Aurora, Illinois 60504 (US)
(72) Inventor: KELEHER, Jason, Aurora, Illinois 60504 (US); SINGH, Pankaj, Aurora, Illinois 60504 (US); BRUSIC, Vlasta, Aurora, Illinois 60504 (US)
(74) Representative: Barker Brettell LLP
(86) International application number: PCT/US2012/020737
(87) International publication number: WO 2012/096931

(56) References cited:
- EP-A2- 1 520 892
- US-A1- 2008 188 079
- US-A1- 2009 029 633
- US-A1- 2009 090 888
- US-A1- 2009 090 888
- US-A1- 2009 134 122
- US-A1- 2009 134 122
- US-A1- 2009 184 287
- US-A1- 2010 029 181
- US-A1- 2010 163 784
- US-B2- 6 866 792

## Description

### FIELD OF THE INVENTION

This invention relates to polishing compositions and methods for polishing a substrate comprising copper and/or silver. More particularly, this invention relates to chemical-mechanical polishing compositions and methods for polishing copper- and/or silver-containing substrates utilizing a combination of a film-forming metal-complexing agent and a metal-passivating agent.

### BACKGROUND OF THE INVENTION

Many compositions and methods for chemical-mechanical polishing (CMP) the surface of a substrate are known in the art. Polishing compositions (also known as polishing slurries, CMP slurries, and CMP compositions) for polishing metal-containing surfaces of semiconductor substrates (e.g., integrated circuits) typically contain abrasives, various additive compounds, and the like, and frequently are used in combination with an oxidizing agent. Such CMP compositions are often designed for removal of specific substrate materials such as metals (e.g., tungsten or copper), insulators (e.g., silicon dioxide, such as plasma-enhanced tertraethylorthosilicate (PETEOS)-derived silica), and semiconductive materials (e.g., silicon or gallium arsenide).

In conventional CMP techniques, a substrate carrier (polishing head) is mounted on a carrier assembly and positioned in contact with a polishing pad in a CMP apparatus. The carrier assembly provides a controllable pressure (down force) to urge the substrate against the polishing pad. The pad and carrier, with its attached substrate, are moved relative to one another. The relative movement of the pad and substrate serves to abrade the surface of the substrate to remove a portion of the material from the substrate surface, thereby polishing the substrate. The polishing of the substrate surface typically is further aided by the chemical activity of the polishing composition (e.g., by oxidizing agents present in the CMP composition) and/or the mechanical activity of an abrasive suspended in the polishing composition. Typical abrasive materials include, for example, silicon dioxide (silica), cerium oxide (ceria), aluminum oxide (alumina), zirconium oxide (zirconia), titanium dioxide (titania), and tin oxide.

The abrasive desirably is suspended in the CMP composition as a colloidal dispersion, which preferably is colloidally stable. The term "colloid" refers to the suspension of abrasive particles in the liquid carrier. "Colloidal stability" refers to the maintenance of that suspension during a selected period of time with minimal settling. In the context of this invention, an abrasive suspension is considered colloidally stable if, when the suspension is placed into a 100 mL graduated cylinder and allowed to stand without agitation for a period of time of 2 hours, the difference between the concentration of particles in the bottom 50 mL of the graduated cylinder ([B] in terms of g/mL) and the concentration of particles suspended in the top 50 mL of the graduated cylinder ([T] in terms of g/mL) divided by the initial concentration of particles suspended in the abrasive composition ([C] in terms of g/mL) is less than or equal to 0.5 (i.e., ([B] - [T])/[C] ≤ 0.5). The value of ([B]-[T])/[C] desirably is less than or equal to 0.3, and preferably is less than or equal to 0.1.

U.S. Pat. No. 5,527,423 to Neville et al.*,* for example, describes a method for chemically-mechanically polishing a metal layer by contacting the surface of the metal layer with a polishing slurry comprising high purity fine metal oxide particles suspended in an aqueous medium. Alternatively, the abrasive material may be incorporated into the polishing pad. U.S. Pat. No. 5,489,233 to Cook et al. discloses the use of polishing pads having a surface texture or pattern, and U.S. Pat. No. 5,958,794 to Bruxvoort et al. discloses a fixed abrasive polishing pad.

US 2009/090888 A1, US 2009/184287 A1, EP 1 520 892 A2, US 2008/188079 A1, US 2009/134122 A1 disclose each chemical-mechanical polishing aqueous compositions for polishing copper.

For copper CMP applications it often is desirable to use a relatively low-solids dispersion (i.e., having an abrasive concentration at a total suspended solids (TSS) level of 1 percent by weight or less), which is chemically reactive toward copper. Chemical reactivity can be modulated through the use of oxidizing agents, chelating agents, corrosion inhibitors, pH, ionic strength, and the like. Balancing the chemical reactivity and mechanical abrasive properties of the CMP slurry can be complicated. Many commercial copper CMP slurries are highly chemically reactive, and exhibit high copper static etch rates (SER) of well over 100 Angstroms-per-minute (Å/min), which can be controlled, at least in part, by organic corrosion inhibitors, such as benzotriazole (BTA), triazoles, and imidazoles. Such compositions often do not have good corrosion control after polishing, however. Common commercial copper CMP slurries also frequently suffer from dishing-erosion, defectivity, and surface topography problems.

Another metal of interest in semiconductor applications is silver, which shares many properties and characteristics in common with copper *vis-à-vis* CMP, such as corrosion properties and passivating properties. For example, both silver and copper effectively form films with and are passivated by benzotriazole. In addition, Cu and Ag both readily dissolve in acidic pH with a formation of metal ions (for Cu, Cu⁺¹ and Cu⁺² and for silver Ag⁺¹) and passivate at higher pHs with a formation of oxides.

There is an ongoing need to develop new CMP compositions and methods utilizing relatively low-solids CMP slurries with a reduced level of dishing-erosion and defectivity, relatively high copper and/or silver removal rates, as well as superior corrosion protection and surface inhibition compared to conventional CMP slurries. These and other advantages of the invention, as well as additional inventive features, will be apparent from the description of the invention provided herein.

### SUMMARY OF THE INVENTION

The present invention provides chemical-mechanical polishing (CMP) compositions and a method for polishing substrates comprising copper and/or silver. The method of the present invention entails abrading a surface of the substrate with a CMP composition of the invention, preferably in the presence of an oxidizing agent (e.g., hydrogen peroxide). The compositions and the method of the invention can provide relatively high copper and/or silver removal rates with good passivation, compared to conventional CMP slurries.

The CMP compositions of the invention comprise a particulate abrasive, a primary film-forming metal-complexing agent, a secondary film-forming metal-passivating agent, and an aqueous carrier, as defined in the claims. Examples of metal-complexing agents include compounds of general formula (I): A-X-Y-OH, salts thereof, and partially neutralized forms thereof (e.g., a combination of acid form and a salt form), in which A is -N(R¹)-C(=O)-R² or -C(=O)-NH-OH; and either X is -C(R³)(R⁴)- and Y is -C(=O)-, or X and Y together form an aryl group in which the A and OH groups in formula (I) are positioned in a 1,2 or "ortho" relationship to one another. In formula (I), R¹ is H, substituted C₁-C₄ alkyl, or unsubstituted C₁-C₄ alkyl; R² is substituted C₈-C₂₀ alkyl or unsubstituted C₈-C₂₀ alkyl; and R³ and R⁴ are each independently H, substituted C₁-C₄ alkyl, or unsubstituted C₁-C₄ alkyl. Compounds of formula (I) include N-acyl glycine compounds (e.g., N-lauroyl glycine and N-lauroyl sarcosine), *o*-hydroxyaryl hydroxamic acid compounds (e.g., salicylhydroxamic acid), o-hydroxy-N-acyl aniline compounds, and malonomonohydroxamic acid. The primary film-forming metal-complexing agent according to claim 1 comprises an o-hydroxyaryl hydroxamic acid, as well as the salts and partially neutralized forms thereof. Preferred salt forms of the metal-complexing agents are alkali metal salts (e.g., lithium, sodium, and potassium salts). The composition of the invention comprises 0.01 to 10 percent by weight (wt %) of a particulate abrasive, 0.001 to 1 wt % of the primary film-forming metal-complexing agent, and 0.005 to 0.5 wt % of the secondary film-forming metal-passivating agent, dissolved and/or suspended in an aqueous carrier.

The primary film-forming metal-complexing agent is believed to act as an anchor molecule for produce a thin film directly on the copper surface. The secondary film-forming passivating agent has a strong affinity (e.g., by ionic and/or covalent bonding) for binding to the film formed by the complexing agent. The initial anchor film and the passivating film formed thereon together provide a passivating film that affords a desirably lower static etch rate (SER) and lower friction development over time compared to the use of either the complexing agent or the secondary film-forming passivating agent alone. The two components thus surprising act in a synergistic manner.

The secondary film-forming metal-passivating agents are compounds having the general formula (II): Z-X²(Y²R⁵)(Y³R⁶), as well as salts thereof, and partially neutralized forms thereof. In formula (I), Z is NH₂ or OH; X² is P=O or C; Y² and Y³ are each independently N, NH, or O; and R⁵ and R⁶ can each independently comprise R⁷-(OCH₂CH₂)ₙ-, wherein R⁷ can be H, C₁-C₂₀-alkyl, phenyl, C₁-C₂₀-alkyl-substituted phenyl; and wherein "n" has an average value in the range of 2 to 1000, or when Y² and Y³ each independently are N or NH, R⁵ and R⁶ each independently can be N, NH, or CH, and together form a five-membered ring heterocycle with X², Y² and Y³. Thus, in some embodiments, R⁵ and Y⁶ each independently are selected from alkyl or polyethylene glycol (PEG) groups such as poly(oxyethylene), aryl-terminated poly(oxyethylene), alkyl-terminated poly(oxyethylene), and alkylaryl-terminated poly(oxyethylene). Non-limiting examples of compounds of formula (II) include amino-substituted heterocycles such as 5-aminotetrazole, and phosphate esters such as bis-pegylated phosphate esters), particularly phosphates esterified with PEG chains at two oxygens of the phosphate group, wherein the PEG chains are terminated by an aryl ether group (e.g., a phenyl ether), an alkylphenyl ether group (e.g., a C₁-C₂₀-alkyl-substituted phenyl, such as nonylphenyl), or a C₁-C₂₀-alkyl ether group (e.g., bis-(nonylphenylpoly(oxyethylene) phosphate diester). Preferred salt forms of the metal-passivating agents are alkali metal salts (e.g., sodium and potassium salts) in the case of acidic materials and mineral acid addition salts in the case of basic materials.

Optionally, the compositions of the present invention can include one or more auxiliary metal (e.g., cooper and/or silver)-chelating agents (e.g., 0.01 to 20 wt % of the auxiliary metal-chelating agent) such as compounds having an acidic OH group and an additional oxygen-bearing or nitrogen-bearing substituent. Non-limiting examples of such auxiliary metal-chelating agents include oxalic acid, amino-substituted carboxylic acids (e.g., alpha-amino acids such as glycine, or amino polycarboxylic acids, such as iminodiacetic acid, and the like), and hydroxyl-substituted carboxylic acids (e.g., citric acid, and the like), as well as salts of the chelating agents (e.g., alkali metal salts).

### BRIEF DESCRIPTION OF THE DRAWINGS

FIG. 1 shows the chemical structures of examples of primary film-forming metal-complexing agents including compounds of general formula (I).
FIG. 2 provides two schematic representations of possible mechanisms by which the primary and secondary film-formers passivate a metal surface and reduce polishing drag force.
FIG. 3 shows plots of copper removal rate (Cu RR) versus down force (DF) obtained by polishing copper wafers utilizing a composition comprising a primary film-forming metal-complexing agent and an auxiliary chelating agent not according to the invention, compared to results obtained with a control composition.
FIG. 4 provides a contour plot of static etch rate (SER) as a function of the level of the primary film-forming metal-complexing agent (anchor molecule) and the secondary film-forming metal-passivating agent for CMP compositions containing salicylhydroxamic acid (SHA) and 5-aminotetrazole (ATA).
FIG. 5 shows a plot of drag force as a function of polishing time for a CMP composition containing SHA and ATA (C8200 Cl) compared to a similar composition without ATA (C8200 POR).
FIG. 6 shows a plot of 100 µm line dishing as a function of the level of ATA for a CMP composition containing SHA and ATA (C8200 Cl) compared to a similar composition without ATA (C8200 POR).
FIG. 7 shows a plot of SER as a function of bis-(nonylphenylpoly(oxyethylene)) phosphate diester (NPPOP) level in CMP compositions containing SHA (anchor molecule) and NPPOP (Secondary Molecule) compared to a similar compositions including only the anchor molecule or the secondary molecule.
FIG. 8 shows a plot of 100 µm line dishing as a function of the level ofNPPOP for a CMP composition containing SHA and NPPOP (C8800) compared to a similar composition without the phosphate diester (C8200 POR).

### DETAILED DESCRIPTION OF PREFERRED EMBODIMENTS

The CMP compositions of the invention comprise a particulate abrasive, a primary film-forming metal-complexing agent, a secondary film-forming metal-passivating agent, and an aqueous carrier therefor, and provide for relatively high copper removal rates, relatively low defectivity, and good surface passivation when used to polish a substrate comprising copper and/or silver. In particular, the compositions of the present invention provide lower SER and lower friction over time relative to conventional compositions that do not include the primary and secondary film-forming materials.

Particulate abrasives useful in the CMP compositions and methods of the invention include any abrasive material suitable for use in CMP of semiconductor materials. Non-limiting examples of suitable abrasive materials include silica (e.g., fumed silica and/or colloidal silica), alumina, titania, ceria, zirconia, or a combination of two or more of the foregoing abrasives, which are well known in the CMP art. Preferred abrasives include silica, particularly colloidal silica, as well as titania. The abrasive material preferably is present in the CMP slurry at a concentration of not more than 10 wt %, preferably not more than 5 wt %. In some preferred embodiments, the abrasive material is present in the CMP composition at a concentration in the range of 0.1 to 1 wt %. Preferred abrasives have a mean particle size of 100 nm or less, as determined by laser light scattering techniques, which are well known in the art.

As used herein and in the appended claims, the terms "carboxylate", "carboxylic acid" and any similar related terms, encompass the acid form, the salt form, and partially neutralized forms of a compound that bears a carboxylic acid group (i.e., a -C(=O)OH group). The term "hydroxamic acid" refers to the acid form, the salt form, and partially neutralized forms of a compound that bears a hydroxamic acid group (i.e., -C(=O)NH-OH). Accordingly, all references to metal-complexing agents in the context of the present invention are to be construed as referring to any and all forms of the agents, i.e., the acid form, salt forms, and partially neutralized forms, which are functionally interchangeable with one another at a given pH. The form of the metal-complexing agent actually present in a given composition will depend upon the pKa of any acid functional groups and the pH of the composition.

Primary film-forming metal-complexing agents used in the compositions and methods of the present invention are compounds that include an o-hydroxyaryl hydroxamic acid, a salt thereof, or a partially neutralized form thereof.

Examples of primary film-forming metal-complexing agents having the general formula (I): A-X-Y-OH, as well as salts of formula (I), and combinations of the acid form and a salt form of formula (I), in which A is -N(R¹)-C(=O)-R² or -C(=O)-NH-OH; and either X is -C(R³)(R⁴)- and Y is -C(=O)-, or X and Y together form an aryl group in which the A and OH groups in formula (I) are positioned in a 1,2 or "ortho" relationship to one another. In formula (I), R¹ is H, substituted C₁-C₄ alkyl, or unsubstituted C₁-C₄ alkyl; R² is substituted C₈-C₂₀ alkyl or unsubstituted C₈-C₂₀ alkyl; and R³ and R⁴ are each independently H, substituted C₁-C₄ alkyl, or unsubstituted C₁-C₄ alkyl. Compounds of formula (I) include N-acyl glycine compounds (e.g., N-lauroyl glycine and N-lauroyl sarcosine), *o*-hydroxyaryl hydroxamic acid compounds (e.g., salicylhydroxamic acid), *o*-hydroxy-N-acyl aniline compounds, and malonomonohydroxamic acid. Preferred salt forms are alkali metal salts (e.g., lithium, sodium, and potassium salts). Preferably, the primary film-forming metal-complexing agent is present in the composition at a concentration in the range of 0.001 to 1 wt %, more preferably 0.005 to 0.5 wt % or 0.05 to 0.3 wt %.

The alternative "A" moieties in formula (I) are N-acylamino and hydroxamic acid groups, which share the common characteristic of being polar substituents that include both a nitrogen atom and at least one oxygen atom in close proximity to the nitrogen (i.e., the oxygen and nitrogen of the N-acyl group are separated by a single carbon atom, whereas in the hydroxamic acid there are two oxygen atoms - one that is adjacent to the nitrogen and one that is separated by one carbon atom from the nitrogen). Similarly, the X and Y moieties of formula (I) share the following common characteristics: (I) they each impart acidic character to the OH group (e.g., by virtue of the unsaturated carbon atom to which the OH is bonded), and (2) they collectively provide a 1,6 spacing between the oxygen of the OH group and an oxygen atom of the "A" group. Together, the A, X, Y and OH functional groups in the compounds of formula (I) are arranged in a manner that facilitates binding to copper and/or silver. During use, the compounds adsorb onto the surface of the substrate and provide a passivating film on the metal surface.

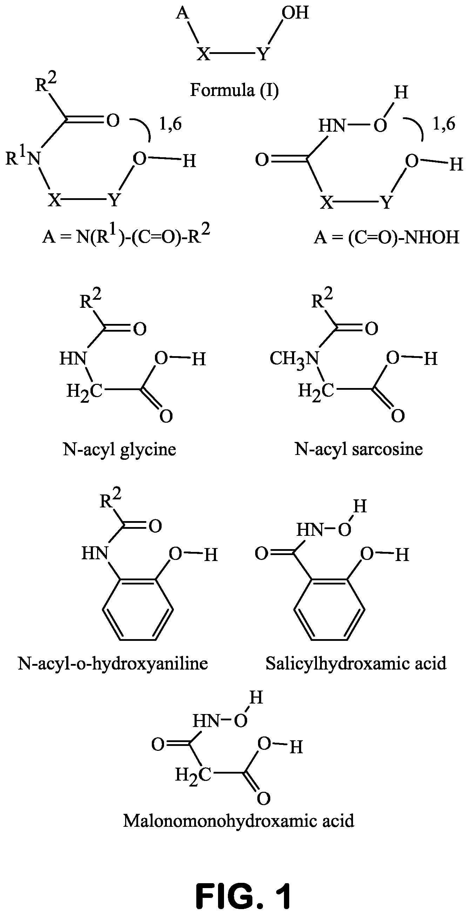

FIG. 1 provides structural formulas for examples of primary film-forming metal-complexing agents including N-acyl glycine and sarcosine compounds, salicylhydroxamic acid, malonomonohydroxamic acid, N-acyl-o-hydroxy aniline compounds, and the like. FIG. 1 also illustrates the 1,6 relationship between the acidic OH and the additional oxygen-bearing substituent in the passivating agents.

The secondary film-forming metal-passivating agents are compounds having the general formula (II): Z-X²(Y²R⁵)(Y³R⁶), as well as salts of formula (II), and partially neutralized forms of formula (II). In formula (I), Z is NH₂ or OH; X² is P=O or C; Y² and Y³ are each independently N, NH, or O; and R⁵ and R⁶ can each independently comprise R⁷-(OCH₂CH₂)ₙ-, wherein R⁷ can be H, C₁-C₂₀-alkyl, phenyl, or C₁-C₂₀-alkyl-substituted phenyl, and wherein "n" has an average value in the range of 2 to 1000, or when Y² and Y³ each independently are N or NH, then R⁵ and R⁶ each independently can be N, NH, or CH, and together form a five-membered ring heterocycle with X², Y² and Y³. Preferably, R⁷ is C₁-C₂₀-alkyl, phenyl, or C₁-C₂₀-alkyl-substituted phenyl. In some preferred embodiments, R⁷ is C₁-C₂₀-alkyl-substituted phenyl, particularly nonylphenyl. Non-limiting examples of compounds of formula (II) include heterocycles (e.g., 5-aminotetrazole, 5-amino-1,2,-4-triazole, and the like), and phosphate esters such as bis-pegylated phosphate esters, particularly phosphate esters that include poly(oxyethylene) chains attached to two oxygens of the phosphate group, wherein the poly(oxyethylene) chains are terminated by an aryl ether group (e.g., phenyl), an alkyl ether group (e.g., a C₁-C₂₀-alkyl, such as lauryl or stearyl), or an alkylaryl ether group (e.g., C₁-C₂₀-alkylphenyl, such as nonylphenyl). As used herein, the terms "poly(oxyethylene)" and "polyethylene glycol" refer to a polymer or oligomer comprising an average of 2 to 1000 oxyethylene (-OCH₂CH₂-) monomer units, preferably 2 to 100 (e.g., 5, 10, 20, 30, 40, 50, 60, 70, 80, or 90) oxyethylene units per poly(oxyethylene) chain. A preferred phosphate ester-type passivating agent is a bis-(nonylphenylpoly(oxyethylene)) phosphate ester (NPPOP), which is commercially available under the trade name SURFONIC® PE 1198, from Huntsman. All references to secondary film-forming metal-passivating agents in the context of the present invention are to be construed as referring to any and all forms of the agent, i.e., the acid form, base form, salt forms, and partially neutralized forms, which are functionally interchangeable with one another at a given pH.

Preferred salt forms of the metal-passivating agents are alkali metal salts (e.g., sodium and potassium salts) in the case of acidic materials and mineral acid addition salts in the case of basic materials. All references to metal-passivating agents herein refer to the acid or base form of the agent, as the case may be, as well as salt forms, and partially neutralized forms thereof. The form of the metal-passivating agent actually present in a given composition will depend upon the pKa of any acid functional groups and the pH of the composition. The secondary film-forming metal-passivating agent is present in the composition in an amount in the range of 0.005 to 0.5 wt %, preferably 0.01 to 0.1 wt %. While not wishing to be bound by theory, it is believed that the secondary film-forming agent forms an additional passivating film over the primary film formed by the metal-complexing agent.

If desired, the compositions of the present invention can include one or more auxiliary metal-chelating agents. Non-limiting examples of auxiliary metal-chelating agents for use in the present invention include oxalic acid, amino-substituted carboxylic acids (e.g., amino polycarboxylates, such as iminodiacetic acid (IDA), ethylenediaminedisuccinic acid (EDDS), iminodisuccinic acid (IDS), ethylenediaminetetraacetic acid (EDTA), nitrilotriacetic acid (NTA), as well as alpha-amino acids, such as glycine, beta-amino acids, and the like); hydroxyl-substituted carboxylic acids (e.g., glycolic acid and lactic acid, as well as hydroxyl polycarboxylic acids, such as malic acid, citric acid, tartaric acid, and the like); phosphonocarboxylic acids; aminophosphonic acids; salts of any of the foregoing; combinations of two or more of the foregoing; and the like. Preferred salts of metal-chelating agents include water soluble salts such as alkali metal salts (e.g., lithium, sodium, and potassium salts).

Preferably, the auxiliary metal-chelating agent is selected from the group consisting of oxalic acid, an amino-substituted carboxylic acid, a hydroxyl-substituted carboxylic acid, a salt thereof, and a combination of two or more of the foregoing, all of which share the common characteristic of at least one carboxylic acid group and a second polar functional group (e.g., a hydroxyl group, an amino group, or an additional carboxylic acid group), which together can cooperatively interact with, and bind to copper and/or silver ions, as the case may be. All references to auxiliary metal-chelating agents herein refer to the acid or base form of the agent, as the case may be, as well as salt forms, and partially neutralized forms thereof. The form of the auxiliary metal-chelating agent actually present in a given composition will depend upon the pKa of any acidic or basic functional groups and the pH of the composition. The metal-chelating agent preferably is present in the composition at a concentration in the range of 0.01 to 20 wt %.

The CMP compositions of the invention preferably have a pH in the range of 5 to 10 (i.e. 5 to 7). The CMP compositions can optionally comprise one or more pH buffering materials, for example, ammonium acetate, disodium citrate, and the like. Many such pH-buffering materials are well known in the art.

The aqueous carrier for the compositions of the present invention preferably is water (e.g., deionized water), and optionally can contain one or more water-miscible organic solvent, such as an alcohol.

The CMP compositions of the invention also optionally can comprise one or more additives, such as a surfactant, a rheological control agent (e.g., a viscosity enhancing agent or coagulant), a biocide, a corrosion inhibitor, an oxidizing agent, and the like, many of which are well known in the CMP art.

The CMP compositions of the invention can be prepared by any suitable technique, many of which are known to those skilled in the art. The CMP composition can be prepared in a batch or continuous process. Generally, the CMP composition can be prepared by combining the components thereof in any order. The term "component" as used herein includes individual ingredients (e.g., abrasives, complexing agents, passivating agents, acids, bases, aqueous carriers, and the like) as well as any combination of ingredients. For example, an abrasive can be dispersed in water, and the metal-passivating agent and metal-complexing agent can be added, and mixed by any method that is capable of incorporating the components into the CMP composition. Typically, an oxidizing agent can be added just prior to initiation of polishing. The pH can be adjusted at any suitable time.

The CMP compositions of the present invention also can be provided as a concentrate, which is intended to be diluted with an appropriate amount of water or other aqueous carrier prior to use. In such an embodiment, the CMP composition concentrate can include the various components dispersed or dissolved in the aqueous carrier in amounts such that, upon dilution of the concentrate with an appropriate amount of aqueous carrier, each component of the polishing composition will be present in the CMP composition in an amount within the appropriate range for use.

The CMP compositions of the present is suitable for polishing substrates comprising copper and/or silver. In another aspect, the present invention provides a method of polishing a substrate comprising copper and/or silver by abrading a surface of the substrate with a CMP composition, as defined in the claims. Preferably, the CMP composition is utilized to polish the substrate in the presence of an oxidizing agent, e.g., 0.1 to 5 percent by weight of an oxidizing agent. Non-limiting examples of useful oxidizing agents include hydrogen peroxide, inorganic and organic peroxo-compounds, bromates, nitrates, chlorates, chromates, iodates, potassium ferricyanide, potassium dichromate, iodic acid and the like. Non-limiting examples of compounds containing at least one peroxy group include hydrogen peroxide, urea hydrogen peroxide, percarbonates, benzoyl peroxide, peracetic acid, di-t-butyl peroxide, monopersulfates (SO₅²⁻), and dipersulfates (S₂O₈²⁻). Non-limiting examples of other oxidizing agents, which contain an element in its highest oxidation state include periodic acid, periodate salts, perbromic acid, perbromate salts, perchloric acid, perchlorate salts, perboric acid, perborate salts, and permanganates. Optionally, the substrate can be immersed in a benzotriazole (BTA) solution after abrading the surface of the substrate with the CMP composition. Preferably the BTA solution comprises 0.01 wt% to 0.5 wt % BTA (e.g., 0.1 wt %).

The CMP method of the present invention is particularly suited for use in conjunction with a chemical-mechanical polishing apparatus. Typically, the CMP apparatus comprises a platen, which, when in use, is in motion and has a velocity that results from orbital, linear, and/or circular motion. A polishing pad is mounted on the platen and moves with the platen. A polishing head holds a substrate to be polished in contact with the pad and moves relative to the surface of the polishing pad, while urging the substrate against the pad at a selected pressure (down force) to aid in abrading the surface of the substrate. A CMP slurry is pumped onto the polishing pad to aid in the polishing process. The polishing of the substrate is accomplished by the combined abrasive action of the moving polishing pad and the CMP composition of the invention present on the polishing pad, which abrade at least a portion of the surface of the substrate. The polishing is also aided by the chemical activity of the CMP composition (i.e., oxidation, complexation, passivation, and the like).

The method of the present invention can utilize any suitable polishing pad (e.g., polishing surface). Non-limiting examples of suitable polishing pads include woven and nonwoven polishing pads, which can include fixed abrasives, if desired. Moreover, polishing pads can comprise any polymer that has a suitable density, hardness, thickness, compressibility, ability to rebound upon compression, compression modulus, chemical compatibility, and the like. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

Desirably, the CMP apparatus further comprises an *in situ* polishing endpoint detection system, many of which are known in the art. Techniques for inspecting and monitoring the polishing process by analyzing light or other radiation reflected from a surface of the workpiece are known in the art. Such methods are described, for example, in U.S. Patent 5,196,353 to Sandhu et al.*,* U.S. Patent 5,433,651 to Lustig et al.*,* U.S. Patent 5,949,927 to Tang, and U.S. Patent 5,964,643 to Birang et al. Desirably, the inspection or monitoring of the progress of the polishing process with respect to a workpiece being polished enables the determination of the polishing end-point, i.e., the determination of when to terminate the polishing process with respect to a particular workpiece.

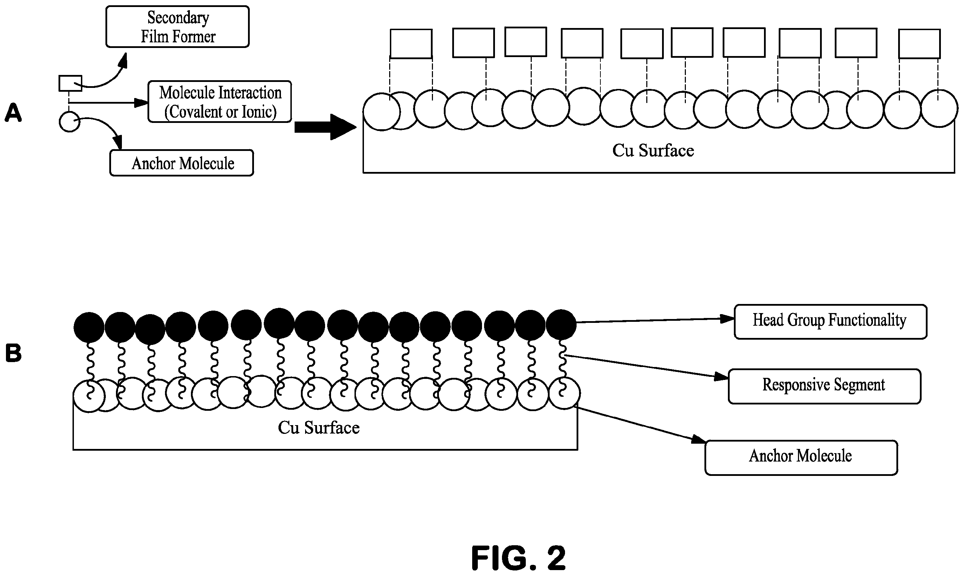

FIG. 2 provides two schematic representations of possible mechanisms by which the compositions of the present invention form metal-passivating films and reduce polishing drag force. Panel A represents a possible mechanism by which compositions including a heterocyclic secondary film-forming metal-passivating agent operate. In Panel A, a primary passivating film is formed directly on a metal (e.g., copper and/or silver) surface by a metal-complexing anchor molecule (e.g., SHA). A secondary film is then formed over the primary film by the heterocyclic metal-passivating agent (e.g., ATA). The combined films inhibit migration of oxidizing agents to the copper surface and provide lubricity, which reduces drag during polishing.

Panel B of FIG. 2 illustrates a possible mechanism for compositions that include a poly(oxyethylene)-type secondary film former (e.g., NPPOP). As in Panel A, the primary film-forming anchor molecule forms a film directly on the metal surface, while the ionic portion of the secondary film-forming metal-passivating agent (e.g., NPPOP) interacts with the primary film, and the hydrophobic head groups of the metal-passivating agent interact with each other. The PEG chains are flexible and responsive to pressure, and thus help to reduce drag during polishing, while the combined composite film provides a physical barrier to inhibit oxidation of the metal surface.

The following non-limiting examples further illustrate various aspects of the present invention.

Examples 1 to 3 are reference examples not according to the invention.

In this specification the following non-SI units are used, which may be converted to the respective SI or metric unit according to the following conversion:
1 inch is 25.4 mm;
1 pound-per-square inch (psi) is 6894.76 Pascal;
1 pound-force (lbf) is 4.45 Newton

### EXAMPLE 1: Evaluation of CMP Compositions Comprising Salicylhydroxamic acid (SHA) and a Metal-Chelating Agent.

CMP compositions having a pH in the range of 5 to 7, containing 50 to 500 ppm of salicylhydroxamic acid (SHA; a primary film-forming metal-complexing agent), 1 percent by weight iminodiacetic acid (IDA; an auxiliary metal-chelating agent), and 0.1 to 1 percent by weight colloidal silica (mean particle size of 80 nm), were utilized to polish 4-inch diameter copper blanket wafers in the presence of 0.8 % by weight hydrogen peroxide. The amounts of SHA, abrasive, and pH of each composition is provided in Table 1. The wafers were polished on a Logitech Model II CDP polisher (Logitech Ltd., Glasgow, UK) under the following operating conditions: a D100 polishing pad, platen speed of 85 revolutions-per-minute (rpm), carrier speed of 93 rpm, down force of either 1 pound-per-square inch (psi) or 3 psi, and a slurry flow rate of 120 milliliters-per-minute (mL/min).

The observed copper removal rates (Cu RR in Å/min) obtained with each composition at 1 and 3 psi down force are also presented in Table 1. The data in Table 1 indicate that at relatively high levels of SHA and neutral pH (i.e., 500 ppm, pH 7) passivation greatly reduces the observed copper removal rate compared to removal rates obtained at lower levels of SHA, regardless of the abrasive level or down force. In contrast, at pH 5, the 500 ppm level of SHA still provided copper removal rates in the range of 1000 to 4000 Å/min. Surprisingly, 0.1 % by weight of abrasive afforded higher removal rates (i.e., 2825 at 1 psi, and 3974 at 3 psi) compared to the composition comprising 1 % by weight abrasive (1082 at 1 psi, 1847 at 3 psi). The copper removal rates obtained compositions comprising 1 % by weight silica and 50 ppm SHA afforded somewhat higher removal rates than the compositions that included 0.1 % by weight silica and 50 ppm SHA regardless of pH (i.e., compare Ex. 1C to 1E and compare Ex. 1D with 1H). Surprisingly, the compositions including 50 ppm SHA exhibited slightly higher copper removal rates at pH 7 compared to pH 5, regardless of the abrasive level (compare Ex. 1D with 1E, and compare Ex. 1H with 1C). This is in contrast to the compositions having higher levels of SHA (500 ppm), which exhibited higher removal rates at pH 5 rather than pH 7, as noted above. In each example, the removal rate increased with increasing down force. Passivation by SHA was also confirmed electrochemically (i.e., by a Tafel plot).

**Table 1.**

| **Example #** | **SHA, ppm** | **pH** | **% Abrasive** | **Cu RR, 1 psi** | **Cu RR, 3 psi** |
|---|---|---|---|---|---|
| 1A | 500 | 5 | 1 | 1082 | 1847 |
| 1B | 275 | 6 | 0.55 | 2636 | 4303 |
| 1C | 50 | 5 | 0.1 | 2832 | 4004 |
| 1D | 50 | 7 | 1 | 3376 | 5273 |
| 1E | 50 | 5 | 1 | 3074 | 4863 |
| 1F | 500 | 7 | 1 | 258 | 443 |
| 1G | 500 | 7 | 0.1 | 184 | 246 |
| 1H | 50 | 7 | 0.1 | 2964 | 4162 |
| 1I | 500 | 5 | 0.1 | 2825 | 3974 |

In a separate experiment, the copper static etch rate (SER) was determined for a composition comprising 0.5 % by weight of the colloidal silica, 1 % by weight glycine, and 250 ppm (0.025 %) SHA in water at pH 6 containing 0.8 % by weight hydrogen peroxide. The SER was measured by immersing a 1-inch square copper wafer in 200 grams of the CMP composition for 10 to 30 minutes. The thickness of the copper layer was measured before and after immersion. The SER (in Å/min) was calculated by the following formula: SER = (change in copper thickness in Å)/(the duration of the test in minutes). The observed SER was 17 Å/min, indicating good passivation. A control composition having no SHA had a SER of 1342 Å/min.

### EXAMPLE 2: Evaluation of CMP Compositions Comprising N-Lauroyl Sarcosine (NLS) and Iminodiacetic Acid (IDA).

CMP compositions were utilized to polish 4-inch diameter copper blanket wafers. The compositions included 0.1 percent by weight of colloidal silica abrasive (mean particle size of 80 nm), 100 ppm or 1000 ppm of N-lauroyl sarcosine (NLS), in combination with 1 percent by weight of IDA. The wafers were polished on a Logitech Model II CDP polisher (Logitech Ltd., Glasgow, UK) in the presence of 0.8 percent by weight hydrogen peroxide at a pH of 7, under the following operating conditions: a D100 polishing pad, platen speed of 85 rpm, carrier speed of 93 rpm, down force of 1 or 3 psi, and a slurry flow rate of 120 mL/min. The SER for each composition was also determined.

The composition containing 100 ppm of the NLS exhibited a static etch rate (SER) for copper of 34 Å/min, while the composition containing 1000 ppm of NLS had a SER of 5 Å/min. The composition containing 100 ppm of NLS also exhibited relatively high copper removal rates (3220 and 4400 Å/min at 1 psi and 3 psi down force, respectively), compared to the composition containing 1000 ppm of NLS, which provided very low copper removal rates at both levels of down force (< 50 Å/min). These results indicate that NLS provides a relatively high level of passivation at the higher level of NLS (1000 ppm).

### EXAMPLE 3: Effect of Down Force on Removal Rate.

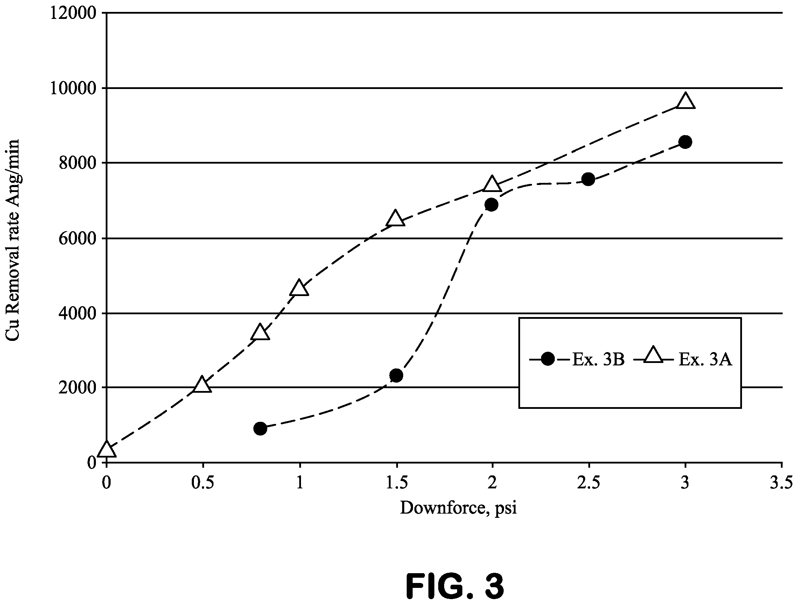

A composition (Ex. 3A) comprising 0.5 % by weight of the colloidal silica, 1 % by weight glycine, and 250 ppm (0.025 %) SHA in water at pH 6 was utilized to polish 4-inch diameter copper blanket wafers on a Logitech polisher in the presence of 0.8 % by weight hydrogen peroxide under the following conditions: a D100 polishing pad, platen speed of 85 rpm, carrier speed of 93 rpm, down force of 0 or 3 psi, and a slurry flow rate of 120 mL/min. For comparison, wafers were also polished utilizing a model CMP slurry (Ex. 3B) comprising 0.5 % by weight of the colloidal silica, and 1 % by weight glycine, in water at pH 6 in the presence of 0.8 % by weight hydrogen peroxide under the same polishing conditions. A plot of Cu Removal Rate versus down force for each composition is provided in FIG. 3 As is readily apparent in FIG. 3 the composition of the (Ex. 3A) provided a surprisingly more linear (Prestonian) response to variation in down force compared to the model composition (Ex. 3B), which did not include SHA. A non-linear response to down force variation can lead to product variability during the polishing process, which is undesirable.

### EXAMPLE 4: Evaluation of Compositions Comprising SHA and ATA.

A series of compositions comprising varying amounts of about SHA and 5-aminotetrazole (ATA) in deionized water were evaluated for static etch rate (SER) as in Example 1. One composition (Ex. 4A), which comprises 0.12 wt % SHA, 0.08 wt % 5-aminotetrazole, 10 wt % glycine, and 5 wt % silica abrasive was used to polish copper blanket wafers on a Logitech Model II CDP polisher (Logitech Ltd., Glasgow, UK) under the following operating conditions: a D100 polishing pad, platen speed of 80 rpm, carrier speed of 75 rpm, down force of 2 psi, and a slurry flow rate of 150 mL/min. SER was determined by measuring the amount of copper lost by dipping 1-inch square copper wafers into the slurry, immersed in an agitated water bath maintained at 50 °C, as is known in the art.

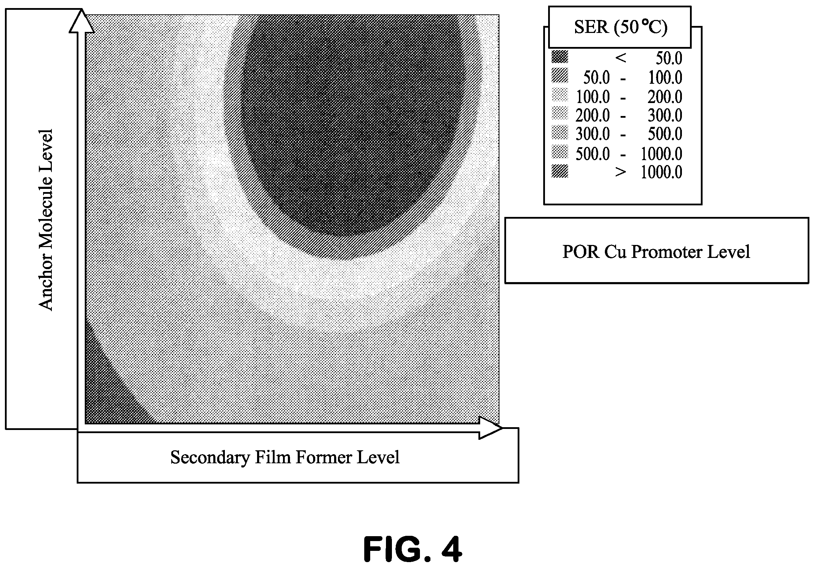

FIG. 4 shows a two-dimensional contour plot of SER as a function of the concentration of SHA (anchor molecule) and ATA (secondary film former). As is evident from the data in FIG. 4, the optimum observed range for the concentrations of SHA and ATA at a temperature of 50 °C, where in the range of 0 to 250 for SHA and 0 to 125 for ATA.

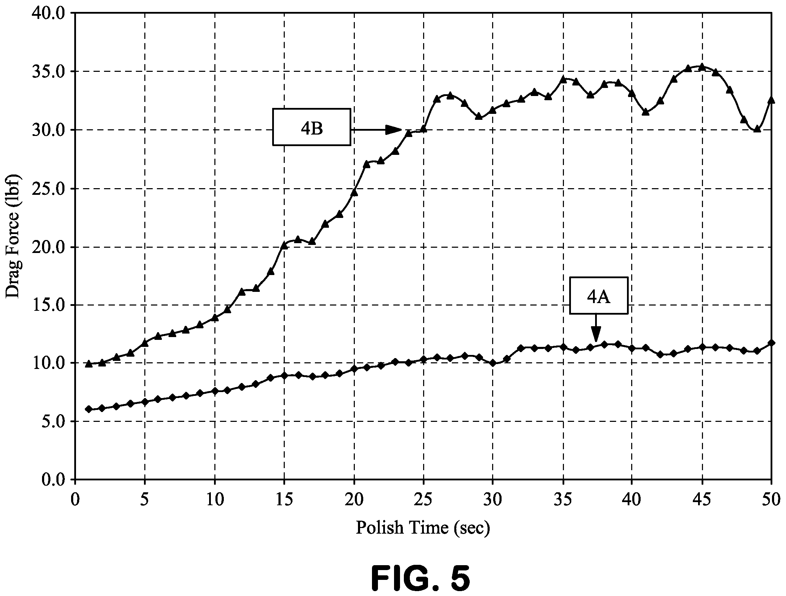

FIG. 5 shows a plot of polishing drag force as a function of polishing time for Ex. 4A (labeled 4A) compared to a similar control composition (labeled 4B) without ATA. Drag force was determined using a pressure transducer, which calculates the drag force based on the lateral deflection of the rotating shaft attached to the polishing head on which the wafer is mounted wafer, as is known in the art. The plots in FIG. 5 clearly show that the addition of ATA significantly reduced the drag force compared to the control composition.

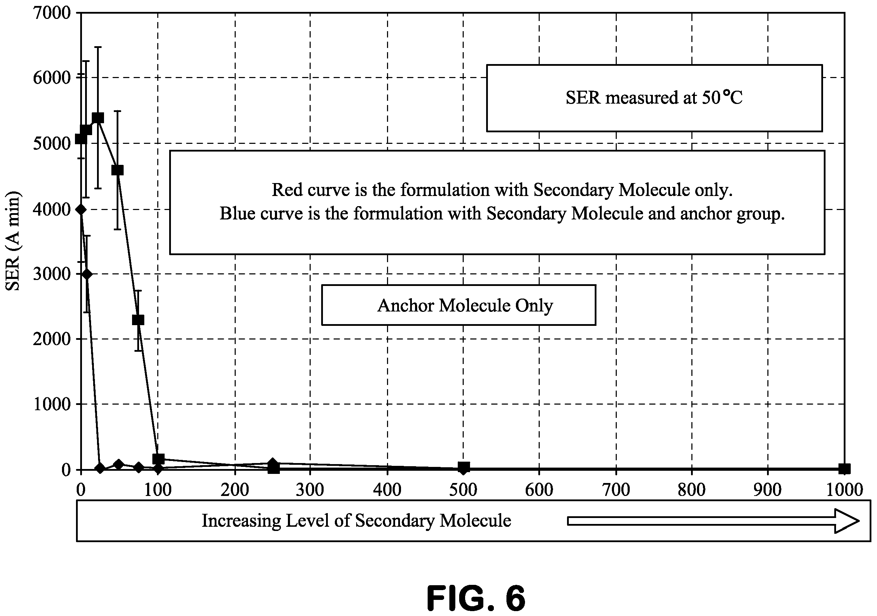

Ex. 4A was also evaluated for over polishing, by measuring dishing on patterned wafers including copper lines on a dielectric substrate. Dishing was assessed by determining the step height of the copper line relative to the surrounding dielectric, as is known in the art. FIG. 6 provides a plot of 100 µm line dishing as a function over-polishing time for a CMP composition containing SHA and ATA (labeled 4A) compared to a similar composition without ATA (labeled 4B). As used herein, the term "over-polishing" (OP) and grammatical variations thereof, refers to the additional polishing time needed to remove potential copper contaminants after an end-point algorithm has determined that copper removal should be complete. For example, if the end-point algorithm determines the end-point to be 60 seconds of polishing, a 50 %OP would translate to 30 seconds additional polishing time. The rate of change of dishing from the end-point time to the over-polish time (as determined by the slope of a plot of dishing versus time between these two points, in Å dishing/%OP) is a measure of the OP "processing window" in which acceptable results can be obtained without significantly compromising dishing performance. The data in FIG. 6 clearly show that the composition of the present invention containing SHA and ATA (labeled 4A) unexpectedly had an OP slope of only 3 Å/%OP at 50 %OP, compared to 11 Å/%OP at only 30 %OP for the control example without ATA (labeled 4B). Accordingly, the processing window (i.e., the potential time period of over polishing without significantly degrading the dishing performance) was significantly improved for the composition of the invention relative to the control.

### EXAMPLE 5: Evaluation of Compositions Comprising SHA and NPPOP.

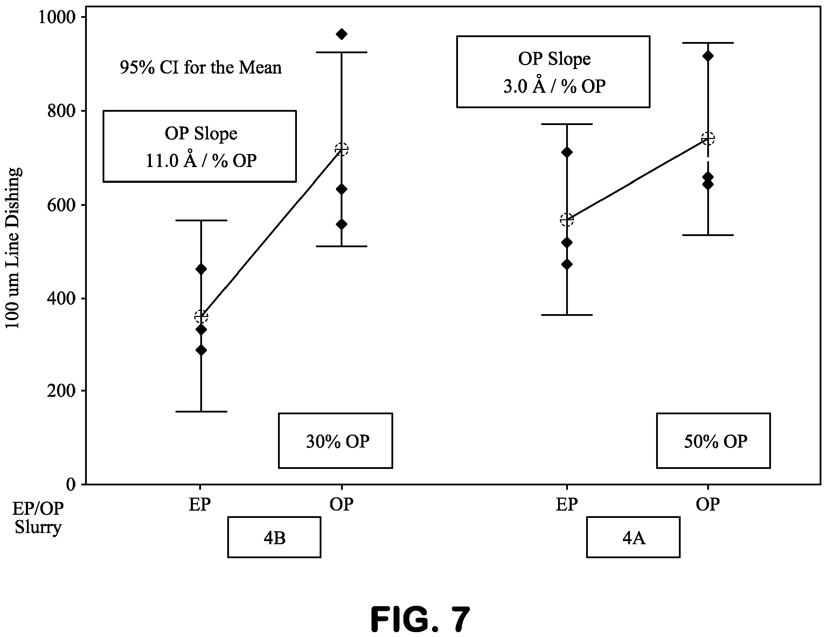

A series of compositions comprising varying amounts of about SHA (anchor) and bis-(nonylphenylpoly(oxyethylene)) phosphate (NPPOP, secondary molecule) in deionized water were evaluated for static etch rate as in Example 1. A plot of SER as a function of NPPOP concentration compared to similar control compositions including only the anchor molecule or the secondary molecule is shown in FIG. 7. The data in FIG. 7 clearly show that addition of the NPPOP greatly reduces the SER compared to the control compositions.

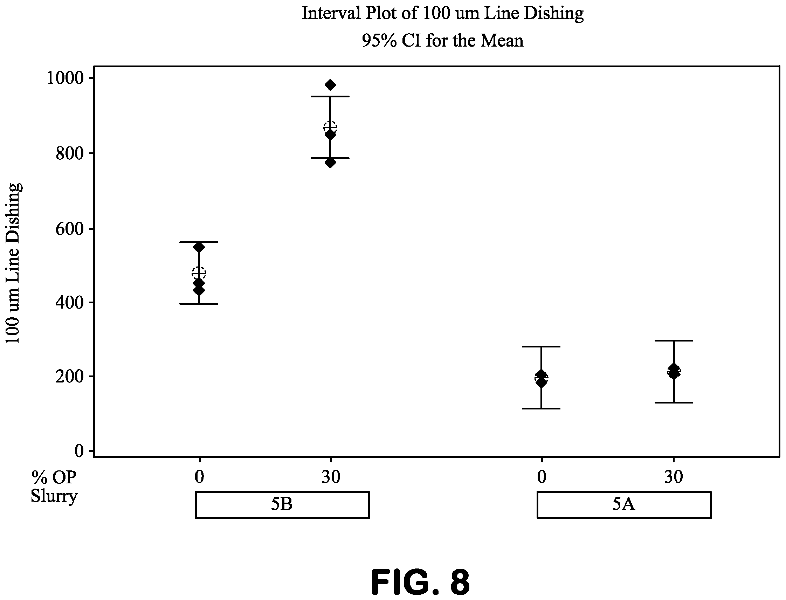

Dishing was also evaluated as in Example 4, for a composition comprising 0.15 wt % SHA, 0.0125 wt % NPPOP, 12.5 wt% glycine and 10 wt % silica abrasive. FIG. 8 shows a plot of 100 µm line dishing versus over-polishing time for the composition of the invention including the NPPOP (labeled 5A) compared to a similar control composition without the phosphate diester (labeled 5B). The data in FIG. 8 show that there was a surprisingly low level of dishing and unexpectedly little change in dishing for the composition of the invention at 30 %OP, compared to the control composition that did not include NPPOP.

### EXAMPLE 6: Evaluation of Compositions Comprising SHA and NPPOP on Ag.

A composition comprising 0.025 wt % SHA, 1.5 wt % glycine, and 1 wt % hydrogen peroxide was used to evaluate the corrosion properties of silver metal in the presence of SHA under static conditions and with abrasion. Another composition that included 0.0013 wt % NPPOP in addition to the SHA, glycine, and hydrogen peroxide was also evaluated, along with a comparison composition that omitted SHA and NPPOP. It was found that addition of SHA reduced the anodic current and increased the corrosion potential relative to the solution

A shown by the results in Table 2, described below, a post CMP protection for silver, similar to that used after Cu CMP, was also explored. The corrosion of silver, measured in 0.05N NaNO₃ under static conditions, is 1 A/min. If, however, Ag is dipped into 0.1 wt % benzotriazole (BTA) solution for 10 minutes after being abraded, its corrosion rate in 0.05N NANO₃ is significantly reduced when reintroduced into a corrosive environment that does not include BTA. Thus, the film formed in BTA solution is stable and provides relatively long-term protection. In general, the post-CMP treatment with BTA lowers the the anodic and cathodic rates and increases the potential, which indicates that the BTA film formed on the silver surface reduces the anodic rate more than the rate of oxidizer (in this case oxygen) reduction, i.e. the film acts as an anodic protector.

**Table 2.**

| | **With Abrasion** | | **Without Abrasion** | |
|---|---|---|---|---|
| | **V diss (mV, MSE)** | **I diss (A/min)** | **V corr (mV, MSE)** | **I corr (A/min** |
| **A** | -10 | 151 | 3 | 151 |
| **B** | 5 | 118 | 9 | 85 |
| **C** | 9 | 92 | 23 | 79 |
| **D** | -15 | 85 | 6 | 82 |
| **E** | -285 | 1 | -143 | 1 |
| **F** | -473 | 1 | -374 | 0.4 |
| **G** | | | -295 | 1 |
| **H** | | | -241 | 0.2 |

Table 2 provides electrochemical silver activity data in a solution containing 0.5 N sodium nitrate, 1 percent hydrogen peroxide and a silver complexing agent, i.e., dissolution potential (V diss) and dissolution current (I diss) with abrasion, as well as corrosion potential (V corr) and corrosion current (I corr) without abrasion, for the compositions described above in this example. In Table 2, entry "A " provides results for the comparative example containing only glycine ; entry "B" provides results for the composition containing glycine + SHA; entry "C" provides results for the composition containing glycine + SHA + NPPOP; entry "D" provides results for the C8800 slurry described in Example 5; entry "E" provides results after abrading the silver and re-immersing in 0.5 N sodium nitrate; entry "F" provides results after abrading the silver and re-immersing in 0.5 N sodium nitrate containing 0.1 wt % BTA; entry "G" provides data after rinsing and drying sample of entry E (not BTA treatment) and re-immersing in the sodium nitrate solution; entry "H" provides data after rinsing and drying sample of entry F (with BTA treatment) and re-immersing in the sodium nitrate solution.

## Claims

1. A chemical-mechanical polishing (CMP) composition suitable for polishing a substrate comprising copper and/or silver, the composition comprising:
(a) 0.01 to 10 percent by weight of a particulate abrasive;
(b) 0.001 to 1 percent by weight of a primary film-forming metal-complexing agent that comprises an o-hydroxyaryl hydroxamic acid, a salt thereof, or a partially neutralized form thereof;
(c) 0.005 to 0.5 percent by weight of a secondary film-forming metal-passivating agent comprising a compound of formula (II): Z-X²(Y²R⁵)(Y³R⁶), a salt thereof, or a partially neutralized form thereof; wherein Z is NH₂ or OH; X² is P=O or C; Y² and Y³ are each independently N, NH, or O; and R⁵ and R⁶ can each independently can be R⁷-(OCH₂CH₂)ₙ-, or when Y² and Y³ each independently are N or NH, then R⁵ and R⁶ each independently can be N, NH, or CH, and together Y² and Y³ form a five-membered ring heterocycle with X², Y² and Y³; each R⁷ independently is H, C₁-C₂₀-alkyl, phenyl, or C₁-C₂₀-alkyl-substituted phenyl; and "n" has an average value in the range of 2 to 1000; and
(d) an aqueous carrier therefor.

2. The composition of claim 1 wherein the secondary film-forming metal-passivating agent comprises an amine-substituted nitrogen heteroaromatic compound, a bis-(poly(oxyethylene)) phosphate ester, and a combination thereof.

3. The composition of claim 1 wherein the secondary film-forming metal-passivating agent comprises an amine-substituted nitrogen heteroaromatic compound.

4. The composition of claim 3 wherein the amine-substituted nitrogen heteroaromatic compound comprises 5-aminotetrazole.

5. The composition of claim 1 wherein the secondary film-forming metal-passivating agent comprises a bis-(poly(oxyethylene)) phosphate ester.

6. The composition of claim 5 wherein the bis-(poly(oxyethylene)) phosphate ester comprises a bis-(nonylphenylpoly(oxyethylene)) phosphate ester.

7. The composition of claim 1 further comprising 0.01 to 20 percent by weight of an auxiliary metal-chelating agent selected from the group consisting of oxalic acid, an amino-substituted carboxylic acid, a hydroxyl-substituted carboxylic acid, a salt thereof, a partially neutralized form thereof, and a combination of two or more of the foregoing.

8. The composition of claim 1 wherein the auxiliary metal-chelating agent comprises glycine.

9. The composition of claim 1 wherein the particulate abrasive comprises silica.

10. The composition of claim 1 in which
the primary film forming agent is salicylhydroxamic acid, a salt thereof or a partially neutralized form thereof; and
the at least one secondary film-forming metal-passivating agent is selected from the group consisting of an amine-substituted nitrogen heteroaromatic compound and a bis-(poly(oxyethylene)) phosphate ester.

11. The composition of claim 10 wherein the at least one secondary film-forming metal-passivating agent comprises 5-aminotetrazole; wherein optionally the at least one secondary film-forming metal-passivating agent comprises a bis-(nonylphenylpoly(oxyethylene)) phosphate ester.

12. A method for chemical-mechanical polishing (CMP) a substrate comprising copper and/or silver, the method comprising abrading a surface of the substrate with a CMP composition, wherein the CMP composition comprises:
(a) 0.01 to 10 percent by weight of a particulate abrasive;
(b) 0.001 to 1 percent by weight of a primary film-forming metal-complexing agent that comprises an o-hydroxyaryl hydroxamic acid, a salt thereof, or a partially neutralized form thereof;
(c) 0.005 to 0.5 percent by weight of a secondary film-forming metal-passivating agent comprising a compound of formula (II): Z-X²(Y²R⁵)(Y³R⁶), a salt thereof, or a partially neutralized form thereof; wherein Z is NH₂ or OH; X² is P=O or C; Y² and Y³ are each independently N, NH, or O; and R⁵ and R⁶ can each independently can be R⁷-(OCH₂CH₂)ₙ-, or when Y² and Y³ each independently are N or NH, then R⁵ and R⁶ each independently can be N, NH, or CH, and together Y² and Y³ form a five-membered ring heterocycle with X², Y² and Y³; each R⁷ independently is H, C₁-C₂₀-alkyl, phenyl, or C₁-C₂₀-alkyl-substituted phenyl; and "n" has an average value in the range of 2 to 1000; and
(d) an aqueous carrier therefor.

13. The method of claim 12 wherein any one or more of the following applies;
a)the secondary film-forming metal-passivating agent is selected from the group consisting of an amine-substituted nitrogen heteroaromatic compound, a bis-(poly(oxyethylene)) phosphate ester, and a combination thereof; and
b) the secondary film-forming metal-passivating agent is selected from the group consisting of a bis-(nonylphenylpoly(oxyethylene)) phosphate ester, 5-aminotetrazole, and a combination thereof.

14. The method of claim 12 wherein the CMP composition further comprises an auxiliary metal-chelating agent selected from the group consisting of oxalic acid, an amino-substituted carboxylic acid, a hydroxyl-substituted carboxylic acid, a salt thereof, a partially neutralized form thereof, and a combination of two or more of the foregoing.

15. The method of claim 12 wherein any one or more of the following applies;
a) the particulate abrasive comprises silica;
b) the surface of the substrate is abraded in the presence of 0.1 to 5 percent by weight of an oxidizing agent; and
c) the method including the additional step of immersing the substrate in a benzotriazole (BTA) solution after abrading the surface of the substrate with the CMP composition.

## Patentansprüche

1. Für das Polieren eines Kupfer und/oder Silber umfassenden Substrats geeignete Zusammensetzung zum chemisch-mechanischen Polieren (CMP), wobei die Zusammensetzung Folgendes umfasst:
(a) 0,01 bis 10 Gewichtsprozent eines teilchenförmigen Schleifmittels;
(b) 0,001 bis 1 Gewichtsprozent eines primären filmbildenden Metallkomplexbildners, der eine o-Hydroxyaryl-hydroxamsäure, ein Salz davon oder eine teilweise neutralisierte Form davon umfasst;
(c) 0,005 bis 0,5 Gewichtsprozent eines sekundären filmbildenden Metallpassivierungsmittels, das eine Verbindung der Formel (II) : Z-X²(Y²R⁵)(Y³R⁶), ein Salz davon oder eine teilweise neutralisierte Form davon umfasst; wobei Z für NH₂ oder OH steht; X² für P=O oder C steht; Y² und Y³ jeweils unabhängig für N, NH, oder O stehen und R⁵ und R⁶ jeweils unabhängig für R⁷-(OCH²CH²)ₙ- stehen können oder dann, wenn Y² und Y³ jeweils unabhängig für N oder NH stehen, R⁵ und R⁶ jeweils unabhängig für N, NH oder CH stehen können, und Y² und Y³ zusammen mit X², Y² und Y³ einen fünfgliedrigen heterocyclischen Ring bilden; R⁷ jeweils unabhängig für H, C₁-C₂₀-Alkyl, Phenyl oder für Phenyl, das mit C₁-C₂₀-Alkyl substituiert ist, steht und "n" einen durchschnittlichen Wert im Bereich von 2 bis 1000 aufweist und
(d) einen wässrigen Träger dafür.

2. Zusammensetzung nach Anspruch 1, wobei das sekundäre filmbildende Metallpassivierungsmittel eine aminsubstituierte heteroaromatische Stickstoffverbindung, einen Bis-(poly(oxyethylen))phosphatester und eine Kombination davon umfasst.

3. Zusammensetzung nach Anspruch 1, wobei das sekundäre filmbildende Metallpassivierungsmittel eine aminsubstituierte heteroaromatische Stickstoffverbindung umfasst.

4. Zusammensetzung nach Anspruch 3, wobei die aminsubstituierte heteroaromatische Stickstoffverbindung 5-Aminotetrazol umfasst.

5. Zusammensetzung nach Anspruch 1, wobei das sekundäre filmbildende Metallpassivierungsmittel einen Bis-(poly(oxyethylen))phosphatester umfasst.

6. Zusammensetzung nach Anspruch 5, wobei der Bis-(poly(oxyethylen))phosphatester einen Bis-(nonylphenylpoly(oxyethylen))phosphatester umfasst.

7. Zusammensetzung nach Anspruch 1, ferner umfassend 0,01 bis 20 Gewichtsprozent eines unterstützenden Metallchelatbildners, der aus der Gruppe bestehend aus Oxalsäure, einer aminosubstituierten Carbonsäure, einer hydroxylsubstituierten Carbonsäure, einem Salz davon, einer teilweise neutralisierten Form davon und einer Kombination von zwei oder mehr der Vorhergehenden ausgewählt ist.

8. Zusammensetzung nach Anspruch 1, wobei der unterstützende Metallchelatbildner Glycin umfasst.

9. Zusammensetzung nach Anspruch 1, wobei das teilchenförmige Schleifmittel Siliciumdioxid umfasst.

10. Zusammensetzung nach Anspruch 1, in der es sich bei dem primären filmbildenden Mittel um Salicylhydroxamsäure, ein Salz davon oder eine teilweise neutralisierte Form davon handelt und das mindestens eine sekundäre filmbildende Metallpassivierungsmittel aus der Gruppe bestehend aus einer aminsubstituierten heteroaromatischen Stickstoffverbindung und einem Bis-(poly(oxyethylen))phosphatester ausgewählt ist.

11. Zusammensetzung nach Anspruch 10, wobei das mindestens eine sekundäre filmbildende Metallpassivierungsmittel 5-Aminotetrazol umfasst; wobei das mindestens eine sekundäre filmbildende Metallpassivierungsmittel gegebenenfalls einen Bis-(poly(oxyethylen))phosphatester umfasst.

12. Verfahren zum chemisch-mechanischen Polieren (CMP) eines Kupfer und/oder Silber umfassenden Substrats, wobei das Verfahren das Abschleifen einer Oberfläche des Substrats mit einer CMP-Zusammensetzung umfasst, wobei die CMP-Zusammensetzung Folgendes umfasst:
(a) 0,01 bis 10 Gewichtsprozent eines teilchenförmigen Schleifmittels;
(b) 0,001 bis 1 Gewichtsprozent eines primären filmbildenden Metallkomplexbildners, der eine o-Hydroxyaryl-hydroxamsäure, ein Salz davon oder eine teilweise neutralisierte Form davon umfasst;
(c) 0,005 bis 0,5 Gewichtsprozent eines sekundären filmbildenden Metallpassivierungsmittels, das eine Verbindung der Formel (II) : Z-X²(Y²R⁵)(Y³R⁶), ein Salz davon oder eine teilweise neutralisierte Form davon umfasst; wobei Z für NH₂ oder OH steht; X² für P=O oder C steht; Y² und Y³ jeweils unabhängig für N, NH, oder O stehen und R⁵ und R⁶ jeweils unabhängig für R⁷-(OCH²CH²)ₙ- stehen können oder dann, wenn Y² und Y³ jeweils unabhängig für N oder NH stehen, R⁵ und R⁶ jeweils unabhängig für N, NH oder CH stehen können und Y² und Y³ zusammen mit X², Y² und Y³ einen fünfgliedrigen heterocyclischen Ring bilden; R⁷ jeweils unabhängig für H, C₁-C₂₀-Alkyl, Phenyl oder für Phenyl, das mit C₁-C₂₀-Alkyl substituiert ist, steht und "n" einen durchschnittlichen Wert im Bereich von 2 bis 1000 aufweist und (d) einen wässrigen Träger dafür.

13. Verfahren nach Anspruch 12, wobei eine oder mehrere der folgenden Aussagen zutreffen:
a) das sekundäre filmbildende Metallpassivierungsmittel ist aus der Gruppe bestehend aus einer aminsubstituierten heteroaromatischen Stickstoffverbindung, einem Bis-(poly(oxyethylen))phosphatester und einer Kombination davon ausgewählt und
b) das sekundäre filmbildende Metallpassivierungsmittel ist aus der Gruppe bestehend aus einem Bis-(nonylphenylpoly(oxyethylen))phosphatester, 5-Aminotetrazol und einer Kombination davon ausgewählt.

14. Zusammensetzung nach Anspruch 12, wobei die CMP-Zusammensetzung ferner einen unterstützenden Metallchelatbildner, der aus der Gruppe bestehend aus Oxalsäure, einer aminosubstituierten Carbonsäure, einer hydroxylsubstituierten Carbonsäure, einem Salz davon, einer teilweise neutralisierten Form davon und einer Kombination von zwei oder mehr der Vorhergehenden ausgewählt ist, umfasst.

15. Verfahren nach Anspruch 12, wobei eine oder mehrere der folgenden Aussagen zutreffen:
a) das teilchenförmige Schleifmittel umfasst Siliciumdioxid;
b) die Oberfläche des Substrats wird in Gegenwart von 0,1 bis 5 Gewichtsprozent eines Oxidationsmittels abgeschliffen und
c) das Verfahren schließt nach dem Abschleifen der Oberfläche des Substrats mit der CMP-Zusammensetzung den zusätzlichen Schritt des Eintauchens des Substrats in eine Benzotriazol(BTA)-Lösung ein.

## Revendications

1. Composition de polissage mécanochimique (CMP) appropriée pour le polissage d'un substrat comprenant du cuivre et/ou de l'argent, la composition comprenant :
(a) 0,01 à 10 pour cent en poids d'un abrasif particulaire ;
(b) 0,001 à 1 pour cent en poids d'un agent complexant les métaux filmogène primaire qui comprend un acide o-hydroxyarylhydroxamique, un sel de celui-ci ou une forme partiellement neutralisée de celui-ci ;
(c) 0,005 à 0,5 pour cent en poids d'un agent passivant les métaux filmogène secondaire comprenant un composé de formule (II) : Z-X²(Y²R⁵)(Y³R⁶), un sel de celui-ci ou une forme partiellement neutralisée de celui-ci ; dans lequel Z est NH₂ ou OH ; X² est P=O ou C ; Y² et Y³ sont chacun indépendamment N, NH ou O ; et R⁵ et R⁶ peuvent chacun indépendamment être R⁷-(OCH₂CH₂)ₙ- ou, lorsque Y² et Y³ sont chacun indépendamment N ou NH, alors R⁵ et R⁶ peuvent chacun indépendamment être N, NH ou CH et Y² et Y³ forment ensemble un hétérocycle à cinq chaînons avec X², Y² et Y³ ; chaque R⁷ est indépendamment H, un groupe alkyle en C₁-C₂₀, un groupe phényle ou un groupe phényle à substitution alkyle en C₁-C₂₀ ; et « n » a une valeur moyenne dans la plage de 2 à 1000 ; et
(d) un véhicule aqueux pour ceux-ci.

2. Composition selon la revendication 1 dans laquelle l'agent passivant les métaux filmogène secondaire comprend un composé hétéroaromatique azoté à substitution amine, un ester d'acide phosphorique de bis(poly(oxyéthylène)) et une association de ceux-ci.

3. Composition selon la revendication 1 dans laquelle l'agent passivant les métaux filmogène secondaire comprend un composé hétéroaromatique azoté à substitution amine.

4. Composition selon la revendication 3 dans laquelle le composé hétéroaromatique azoté à substitution amine comprend du 5-aminotétrazole.

5. Composition selon la revendication 1 dans laquelle l'agent passivant les métaux filmogène secondaire comprend un ester d'acide phosphorique de bis(poly(oxyéthylène)).

6. Composition selon la revendication 5 dans laquelle l'ester d'acide phosphorique de bis(poly(oxyéthylène)) comprend un ester d'acide phosphorique de bis(nonylphénylpoly(oxyéthylène)).

7. Composition selon la revendication 1 comprenant en outre 0,01 à 20 pour cent en poids d'un agent chélatant les métaux auxiliaire choisi dans le groupe constitué par l'acide oxalique, un acide carboxylique à substitution amino, un acide carboxylique à substitution hydroxyle, un sel de ceux-ci, une forme partiellement neutralisée de ceux-ci et une association de deux ou plus de deux de ce qui précède.

8. Composition selon la revendication 1 dans laquelle l'agent chélatant les métaux auxiliaire comprend de la glycine.

9. Composition selon la revendication 1 dans laquelle l'abrasif particulaire comprend de la silice.

10. Composition selon la revendication 1 dans laquelle l'agent filmogène primaire est l'acide salicylhydroxamique, un sel de celui-ci ou une forme partiellement neutralisée de celui-ci ; et
l'au moins un agent passivant les métaux filmogène secondaire est choisi dans le groupe constitué par un composé hétéroaromatique azoté à substitution amine et un ester d'acide phosphorique de bis(poly(oxyéthylène)).

11. Composition selon la revendication 10 dans laquelle l'au moins un agent passivant les métaux filmogène secondaire comprend du 5-aminotétrazole ; dans laquelle éventuellement l'au moins un agent passivant les métaux filmogène secondaire comprend un ester d'acide phosphorique de bis(nonylphénylpoly(oxyéthylène)).

12. Procédé pour le polissage mécanochimique (CMP) d'un substrat comprenant du cuivre et/ou de l'argent, le procédé comprenant l'abrasion d'une surface du substrat avec une composition de CMP, dans lequel la composition de CMP comprend :
(a) 0,01 à 10 pour cent en poids d'un abrasif particulaire ;
(b) 0,001 à 1 pour cent en poids d'un agent complexant les métaux filmogène primaire qui comprend un acide o-hydroxyarylhydroxamique, un sel de celui-ci ou une forme partiellement neutralisée de celui-ci ;
(c) 0,005 à 0,5 pour cent en poids d'un agent passivant les métaux filmogène secondaire comprenant un composé de formule (II) : Z-X²(Y²R⁵)(Y³R⁶), un sel de celui-ci ou une forme partiellement neutralisée de celui-ci ; dans lequel Z est NH₂ ou OH ; X² est P=O ou C ; Y² et Y³ sont chacun indépendamment N, NH ou O ; et R⁵ et R⁶ peuvent chacun indépendamment être R⁷-(OCH₂CH₂)ₙ- ou, lorsque Y² et Y³ sont chacun indépendamment N ou NH, alors R⁵ et R⁶ peuvent chacun indépendamment être N, NH ou CH et Y² et Y³ forment ensemble un hétérocycle à cinq chaînons avec X², Y² et Y³ ; chaque R⁷ est indépendamment H, un groupe alkyle en C₁-C₂₀, un groupe phényle ou un groupe phényle à substitution alkyle en C₁-C₂₀ ; et « n » a une valeur moyenne dans la plage de 2 à 1000 ; et
(d) un véhicule aqueux pour ceux-ci.

13. Procédé selon la revendication 12 dans lequel ce qui suit s'applique :
a) l'agent passivant les métaux filmogène secondaire est choisi dans le groupe constitué par un composé hétéroaromatique azoté à substitution amine, un ester d'acide phosphorique de bis(poly(oxyéthylène)) et une association de ceux-ci ; et/ou
b) l'agent passivant les métaux filmogène secondaire est choisi dans le groupe constitué par un ester d'acide phosphorique de bis(nonylphénylpoly(oxyéthylène)), le 5-aminotétrazole et une association de ceux-ci.

14. Procédé selon la revendication 12 dans lequel la composition de CMP comprend en outre un agent chélatant les métaux auxiliaire choisi dans le groupe constitué par l'acide oxalique, un acide carboxylique à substitution amino, un acide carboxylique à substitution hydroxyle, un sel de ceux-ci, une forme partiellement neutralisée de ceux-ci et une association de deux ou plus de deux de ce qui précède.

15. Procédé selon la revendication 12 dans lequel ce qui suit s'applique :
a) l'abrasif particulaire comprend de la silice ;
b) la surface du substrat est abrasée en présence de 0,1 à 5 pour cent en poids d'un agent oxydant ; et/ou
c) le procédé comprenant l'étape supplémentaire consistant à immerger le substrat dans une solution de benzotriazole (BTA) après abrasion de la surface du substrat avec la composition de CMP.
